# EUROPEAN PATENT APPLICATION

(11) **EP 3 979 322 A1**
(43) Date of publication of application: **06.04.2022**
(21) Application number: 20199276.5
(22) Date of filing: 30.09.2020
(51) Int. Cl.: H01L 27/146

(54) **PIXEL STRUCTURE AND METHOD FOR MANUFACTURING A PIXEL STRUCTURE**

(71) Applicant: AMS Sensors Belgium BVBA, 2600 Berchem (BE)
(72) Inventor: Lin, Dong-Long, 5656 AE Eindhoven (NL); Xhakoni, Adi, 5656 AE Eindhoven (NL)
(74) Representative: Epping - Hermann - Fischer

(57) **Abstract**

A pixel structure (1) comprises a substrate body (10) having a light entrance surface (2), a plurality of first photodiodes (11) formed in the substrate body (10) at a first depth (d1) with respect to the light entrance surface (2), and a second photodiode (12) formed in the substrate body (10) at a second depth (d2) with respect to the light entrance surface (2). The first depth (d1) corresponds to a photon absorption length in a material of the substrate body (10) at a first wavelength range, and the second depth (d2) corresponds to a photon absorption length in the material of the substrate body (10) at a second wavelength range that is different from the first wavelength range.

## Description

The present disclosure relates to a pixel structure for use in semiconductor image sensors and to a method for manufacturing such a pixel structure.

CMOS image sensors are used in a wide range of applications, such as for camera modules and smartphones, tablet computers, laptops etc. Some of these applications, such as photography, rely on sensitivities in the visible optical domain while other applications, such a 3D imaging and identification, require the image sensor to be sensitive in the infrared domain. Due to space constraints in state of the art devices, it is desirable to provide an image sensor that is sensitive in both the visible and in the infrared domain. To this end, conventional image sensors comprise a sensing module having color pixels, each sensitive to a certain portion of the visible spectrum as well as a sensing module having infrared pixels.

Image sensors comprising only color pixels typically have these arranged in a specific pattern, the so-called Bayer filter array pattern, wherein each pixel cell has four pixels that are arranged in a 2x2 matrix, of which two pixels are arranged opposite to each other and are sensitive to the green portion of the visible spectrum, while the other two pixels show sensitives in the blue and red domain, respectively. Implementing an additional infrared pixel in these image sensors is typically achieved by sacrificing one of the green pixels of a Bayer filter array pattern in each pixel cell. However, this leads to the fact that standard demosaicing, or debayering, algorithms that rely on a true Bayer filter array pattern cannot be performed anymore, thus resulting in a deteriorated image quality and/or to complicated computation-intensive algorithms to restore the captured image.

In addition to the images captured in both the visible and the infrared domain having to be interpolated for the missing information due to "blind pixels" for the respective band, a further drawback of such image sensors arises from the fact that pixels for infrared light require a larger surface than those for the visible band due to the higher diffraction limit. This means either that an infrared pixel has an inferior sensitivity than the color pixels or it has to be dimensioned larger than the color pixels, meaning that a combined arrangement is impossible to achieve without sacrificing resolution.

Therefore, an object to be achieved is to provide an improved concept for a pixel structure, which is capable of sensing light at two different wavelength ranges and which overcomes at least one of the problems of existing pixel cells.

This object is achieved with the subject-matter of the independent claims. Embodiments and developments of the improved concept are defined as the dependent claims.

The improved concept is based on the idea of forming an image sensor from pixel structures that feature sensitivities in both the visible and the infrared domain and exploit the different absorption behavior of materials employed for forming the pixel structure. In particular, longer-wavelength infrared photons typically achieve a larger mean penetration depth before being absorbed compared to shorter-wavelength photons in the visible domain. Therefore, a pixel structure according to the improved concept features an arrangement, in which a capturing portion of an infrared photodiode for capturing infrared photons is arranged or buried within the substrate at a larger depth than the capturing portion of the visible photodiodes with respect to a light entrance surface of the pixel structure.

In particular, a pixel structure according to the improved concept comprises a substrate body having a light entrance surface, and a plurality of first photodiodes formed in the substrate body at a first depth with respect to the light entrance surface. The pixel structure further comprises a second photodiode that is formed in the substrate body at a second depth with respect to the light entrance surface. Therein, the first depth corresponds to a photon absorption length and a material of the substrate body at a first wavelength range, while the second depth corresponds to a photon absorption length in the material of the substrate body at a second wavelength range that is different from the first wavelength range.

For example, the first wavelength range comprises at least a portion of the visible spectrum, or alternatively the entire visible spectrum, and the second wavelength range comprises at least a portion of the infrared spectrum, in particular a wavelength range in the near-infrared regime, e.g. around 850 nm and/or 940 nm. Ideally, in these embodiments the first wavelength range can exclude wavelengths in the infrared, while the second wavelength range can exclude wavelengths in the visible domain.

The substrate body is a semiconductor substrate, such as a silicon substrate, while the photodiodes are formed by well structures of different implants and/or doping for defining features such as a depletion region and p-n junctions, for instance. Exact configurations and characteristics of the photodiodes are a well-known concept and are not further detailed throughout this disclosure. For example, the photodiodes are silicon-based photodiodes.

According to the improved concept, photodiodes of the pixel structure for sensing visible photons, i.e. photons at wavelengths between 400 and 700 nm, can be arranged at a first depth within the substrate body that is closer to the light entrance surface than the second depth, in which photodiodes for sensing infrared photons, i.e. photons and wavelengths larger than 800 nm, can be arranged. For a silicon, the mean absorption depth for visible photons is in the order of 10 to 300 µm, and the mean absorption depth for infrared photons is in the order of 1 to 10 mm, both depending on the exact wavelength of the respective photons. Hence, the first and second depths can be chosen accordingly such that capturing regions of the respective photodiodes span across the aforementioned respective absorption depths.

In some embodiments, the pixel structure is a backside illuminated pixel structure.

In contrast to a front-illuminated sensor, which typically comprises a metal wiring layer between the substrate body comprising the photodiodes and a color filter layer, a back-illuminated sensor features the wiring layer behind the substrate body with the photodiodes by flipping the wafer during manufacturing and then thinning its back side such that light reaches the photodiodes without having to pass through the wiring layer. However, a metal layer between the substrate body and the filter layer can be employed in order to reduce cross-talk. Hence, a front-illuminated sensor can comprise two or more metal layers while a back-illuminated sensor comprises one metal layer in between the substrate body and the filter layer in these embodiments. Thus, a backside illuminated sensor significantly improves the efficiency, with which photons are being captured by the capturing layers of the photodiodes.

In some embodiments, the second photodiode is formed at a surface of the substrate body opposite the light entrance surface.

Particularly for backside illuminated sensors, the second photodiode can be formed directly at the surface of the substrate body that faces away from the light entrance surface. In these embodiments, the total thickness of the substrate body can be easily optimized in order for the sensor to achieve the best optical performance while still maintaining a sufficient thickness for a better collection efficiency of longer wavelength photons.

In some embodiments, the first photodiodes comprise color filters and form an array of pixels, in particular a Bayer or Quad-Bayer array.

In these embodiments, each of the plurality of first photodiodes comprises a color filter such that a Bayer, Quad-Bayer or any alternative color filter array arrangement is realized. For example, the pixel structure comprises four first photodiodes arranged in a 2x2 matrix, of which two pixels are arranged opposite to each other and comprise a green color filter, while the other two pixels comprise a blue and a red color filter, respectively. The color filters can alternatively be comprised by a filter layer that is arranged on or above the light entrance surface of the substrate body, for instance.

In some embodiments, the plurality of first photodiodes is arranged side-by-side and/or substantially gapless at the first depth.

Side-by-side in this context means that the plurality of first photodiodes is arranged at the same depth, namely the first depth, with respect to the light entrance surface of the substrate body, and parallel to each other such that the capturing portions of each of the first photodiodes faces the light entrance surface of the substrate body. A substantially gapless arrangement can lead to a greatly reduced footprint of the pixel structure and thus to a higher resolution. However, in applications, in which space is not a constraint and/or larger pixels are employed, gaps can be left to allow for the arrangement of circuit elements, such as transistors, or isolation elements in between the first photodiodes.

In some embodiments, the pixel structure further comprises an implant isolation formed at an intermediate depth and the substrate body that is arranged between the first and the second depths.

An implant isolation arranged between the first depth comprising the plurality of first photodiodes and the second depth comprising the second photodiode can reduce the cross talk by spatially separating the first and the second depths such that an absorption of photons of the first wavelength within the second photodiode and vice versa can be prevented. For example, the implant isolation is an isolation region of a material of the substrate body, e.g. silicon. For example, an N-type photodiode has a P-type isolation region.

In some embodiments, the pixel structure further comprises isolation elements of an opaque material with respect to the first wavelength range, wherein the isolation elements extend from the light entrance surface at least to the first depth.

Isolation elements can be employed in order to reduce cross talk between the plurality of first photodiodes. For example, the isolation elements are formed by trenches that are filled by an opaque material regarding the first and/or second wavelength range, and are arranged vertically in between at least some of the first photodiodes and/or at side surfaces of the pixel structure. Vertical in this context refers to a direction that is perpendicular to a main plane of extension of the substrate body. Instead of an opaque material, the trench can alternatively be filled with several different materials, including an oxide, with a substantially different refractive index than that of the substrate body and of the first and second photodiodes. Alternatively to the trenches, the isolation elements can be implemented by an implant.

In some embodiments, the pixel structure further comprises a readout circuitry that is configured to photo-electrons that are generated by the plurality of first photodiodes and the second photodiode.

For example, the readout circuitry converts the detected photo electrons to a voltage signal for a voltage-type readout.

In some further embodiments, the readout circuitry is arranged at or on a surface of the substrate body opposite the light entrance surface.

The pixel structure can further comprise a functional layer comprising circuitry for performing a readout of the first and second photodiodes. For example, the readout circuit is arranged at or on a surface of the substrate body that is opposite to the light entrance surface. In particular, for backside illuminated pixel structures, the readout circuit including a wiring layer comprising one or more metals can be arranged on a front side of the substrate body. For example, the readout circuit is as CMOS circuit. Alternatively, according to different 3-D stacking technologies, the readout circuit can be arranged in other layers that are not located at or on a surface of the substrate body.

In some embodiments, the pixel structure further comprises a sense node at a surface of the substrate body opposite the light entrance surface, and transfer gates for transferring charges collected by the plurality of first photodiodes and the second photodiode to the sense node.

The pixel structure can comprise a combined sense node for collecting photocurrents generated at the first and second photodiodes. Alternatively, the pixel structure can comprise multiple sense nodes, e.g. one for the first photodiodes and one for the second photodiodes or one for each of the photodiodes, for instance. A plurality of sense nodes can result in more flexibility regarding readout timing or readout control.

In some embodiments, the plurality of first photodiodes has a footprint of less than (1 µm)² and the second photodiode has a footprint of less than (2 µm)².

Current manufacturing technologies allow for pixels sizes in the order of 0.8 µm. This can be used to produce a pixel structure according to the improved concept with an active area in the visible domain with a size of around (1.6 µm)² and a similar, or even larger, e.g. (3.2 µm)², active area in the infrared domain. However, the improved concept can be employed for all pixel sizes depending on the actual application and its requirements to an image sensor formed from the pixel structures.

The aforementioned object is further solved by an image sensor comprising a plurality of pixel structures according to one of the embodiments described above. Therein, the image sensor is configured to generate image signals at the first and the second wavelength ranges.

Such an image sensor can be conveniently employed in electronic devices, such as smart phones, tablet computers and laptops, for example in a camera module that is required to operate at two different wavelength ranges. For example, the camera module is configured to operate in the visible domain for photography and/or video capturing and in the infrared domain for 3-D imaging and/or identification purposes.

The aforementioned object is further solved by a method for manufacturing a pixel structure. The method comprises providing a substrate body having a light entrance surface, and forming a plurality of first photodiodes in the substrate body at a first depth with respect to the light entrance surface. The method further comprises forming a second photodiode in the substrate body at a second depth with respect to the light entrance surface. The first depth corresponds to a photon absorption length and a material of the substrate body at a first wavelength range, and the second depth corresponds to a photon absorption length and the material of the substrate body at a second wavelength range that is different from the first wavelength range.

Advantages of a pixel structure and its manufacturing method according to the improved concept are the high flexibility of the photodiode tuning, e.g. in terms of sensitivity regarding center wavelength and wavelength range, a reduced process correlation to logic wafer, less area loss compared to conventional 2D-designs, in which in a Bayer-arrangement one of the green photodiodes is replaced as an infrared-sensitive photodiode.

Further embodiments of the method become apparent to the skilled reader from the embodiments of the pixel cell and pixel cell arrangement described above.

The following description of figures of exemplary embodiments may further illustrate and explain aspects of the improved concept. Components and parts of the pixel structure with the same structure and the same effect, respectively, appear with equivalent reference symbols. Insofar as components and parts of the pixel cell correspond to one another in terms of their function in different figures, the description thereof is not repeated for each of the following figures.

In the figures:
- Figures 1 to 4: show exemplary embodiments of a pixel structure according to the improved concept; and
- Figures 5 to 7: show exemplary embodiments of an image sensor according to the improved concept.

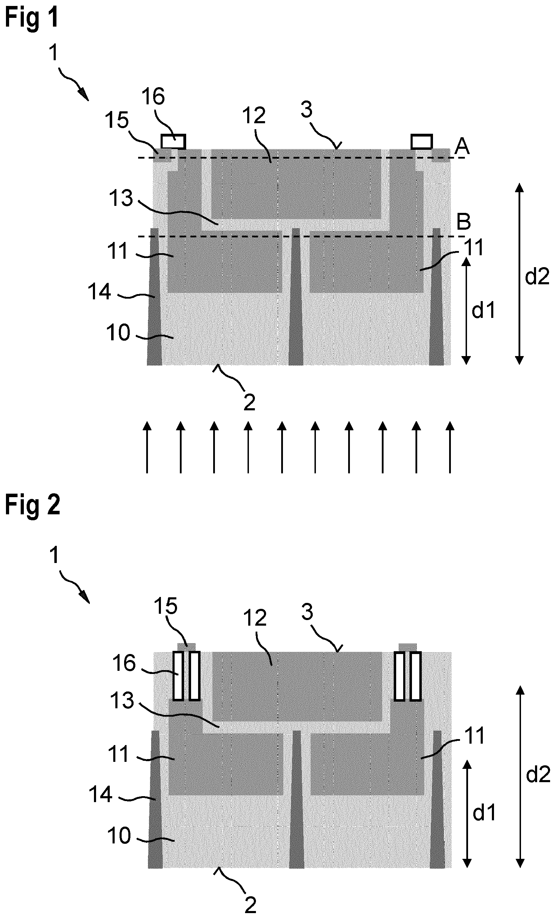

Figure 1 shows a cross-sectional view of an exemplary embodiment of the pixel structure 1 according to the improved concept. The pixel structure comprises a substrate body 10, in which a plurality of first photodiodes 11 are arranged at a first depth d1 with respect to a light entrance surface 2 of the pixel structure. A second photodiode 12 is arranged at a depth d2 that is larger than the first depth d1. In this embodiment, a thickness of the substrate body 10 results in the second photodiode 12 to be arranged at a surface 3 of the substrate body that is opposite to the light entrance surface 2. The figure focuses on the capturing, or depletion, regions of the respective photodiodes, which are formed as a well structure, for instance. For the first photodiodes 11, electrical contacting from the capturing region to the surface 3 are indicated.

The first depth d1 corresponds to an absorption depth in silicon, for example, of photons at a first wavelength or a first wavelength range measured from the light entrance surface 2. Correspondingly, the second depth d2 corresponds to absorption depth in silicon of photons at a second wavelength or a second wavelength range. Therein, the first wavelength range comprises visible light, while the second wavelength comprises infrared, in particular near-infrared light. In the figure, incident light is indicated as arrows pointing at the light entrance surface 2. For example, the pixel structure 1 is a backside illuminated pixel structure.

For example, the substrate body 10 is a silicon substrate, such as a chip or a part of a wafer, and the photodiodes 11, 12 are silicon-based photodiodes realized by differently doped silicon regions, for instance. The pixel structure 1 further comprises one or more floating diffusions 15 and transfer gates 16, in this embodiment arranged on or at the surface 3. For illustration purposes, said elements are only shown for the first photodiodes 11.

The pixel structure in this embodiment further comprises an implant isolation 13 formed between the first and the second depths d1, d2. The implant isolation 13 is realized as a barrier layer between the first and the second photodiodes 11, 12. For example, the implant isolation 13 is an isolation region of silicon. A thickness of the implant isolation 13 can be tuned in order to minimize cross talk between the first and second photodiodes 11, 12, in particular between those of the first photodiodes 11 that are sensitive to wavelength corresponding to visible light and the second photodiode 12 that is sensitive to near-infrared light. Moreover, the implant isolation 13 spatially separates the first and second photodiodes 11, 12 in the direction of the propagating light such that an absorption of photons at the first wavelength within the capturing region of the second photodiode 12 and an absorption of photons at the second wavelength within the capturing region of the first photodiodes 11 can be prevented.

The pixel structure in this embodiment further comprises isolation elements 14 that are arranged in between the first photodiodes 11 in order to laterally separate these. For example, the isolation elements 14 are realized by trenches that are formed within the substrate body, extend from the light entrance surface 2 at least to the first depth d1, and are filled with a transparent or an opaque material regarding the first wavelength, e.g. a silica, for instance. The isolation elements 14 are formed in order to reduce cross talk between the plurality of first photodiodes 11.

In some embodiments not shown, the pixel structure can further comprise color filters, e.g. arranged on or above the light entrance surface 2, such that each of the first photodiodes 11 has a color filter. For example, the color filters realize a Bayer or Quad-Bayer arrangement of the first photodiodes 11.

Figure 2 shows an alternative embodiment of a pixel structure 1 similar to that shown in the previous Figure 1. In this embodiment, the transfer gates 16 are realized in a vertical manner, e.g. for collecting charges generated within the first photodiodes 11 in a middle size pixel design.

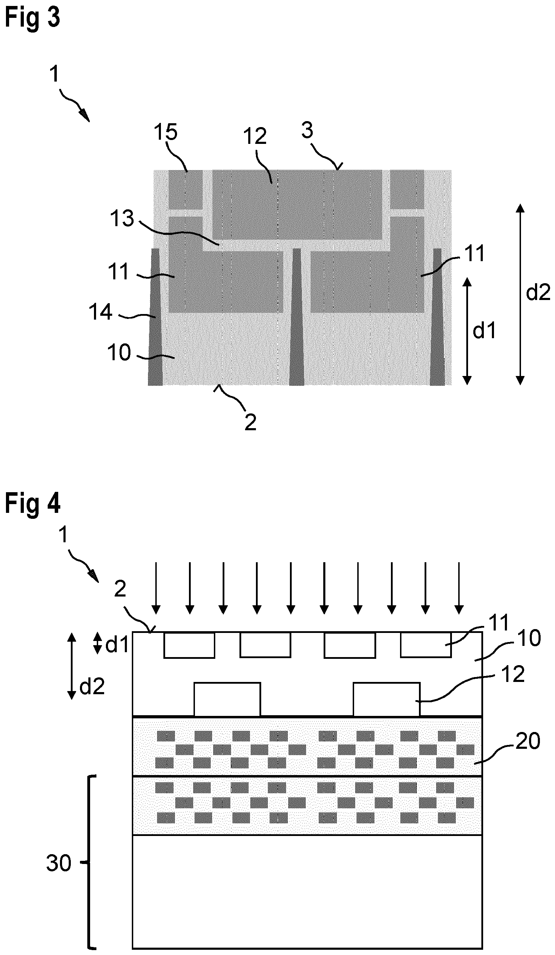

Figure 3 shows an alternative embodiment of a pixel structure 1 similar to that shown in the previous Figures 1 and 2. In this embodiment, an electric file design without transfer gates is realized for controlling the transfer in a small size pixel design.

The described embodiments represent different ways to transfer photo-electrons from the photodiode to a floating diffusion region. In particular, the shown embodiments can be advantageously employed also in small pixel size designs. After the respective signals have been transferred to the floating diffusion node, the readout design corresponds to that known from typical pinning pixels, for instance.

Figure 4 shows a cross-sectional view of a further embodiment of the pixel structure 1. In this embodiment, the first photodiodes 11 are arranged at a first depth d1 at the light entrance surface, while the second photodiodes 12 are arranged at a larger second depth d2, analogously to the embodiments shown in Figures 1 to 3. Furthermore, a functional layer 20 comprising electrical contacts for contacting the photodiodes 11, 12 is arranged on the surface 3 of the substrate body 10 opposite the light entrance surface 2.

A readout component 30, likewise having a functional layer comprising electrical contacts corresponding to those of the functional layer 20, is arranged on the functional layer 20. For example, the readout component 30 comprises circuit elements for reading out the respective photocurrents generated by the first and second photodiodes 11, 12. For example, the readout component 30 is realized as a separate chip that is bonded to the pixel structure 1 after manufacturing of the separate components.

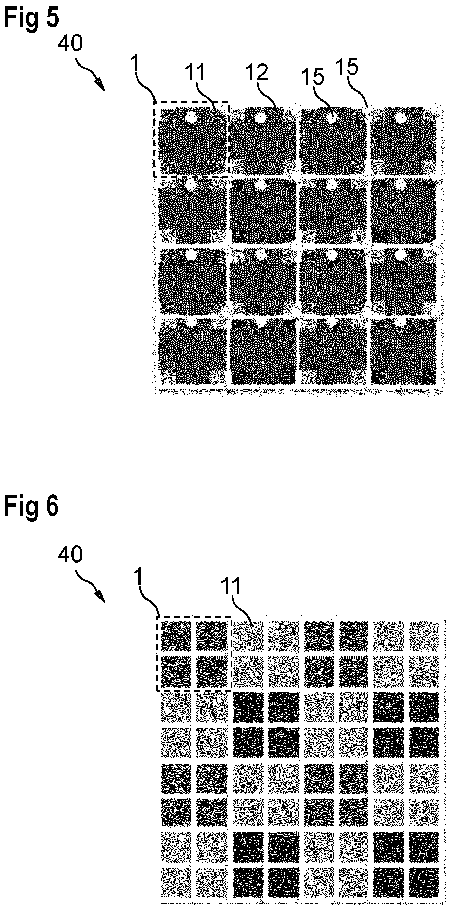

Figure 5 shows a top view of a profile of an image sensor 40 comprising a 4x4 matrix of pixel structures 1 of Figure 1, wherein the profile is illustrated at a depth that is indicated by the dashed line A in Fig. 1. The surface at this depth is dominated by the depletion region of the second photodiode 12 with components of the first photodiodes arranged in the respective corners of each pixel structure.

In this view, also the floating diffusions 15 are illustrated, wherein the second photodiode 12 of each pixel structure 1 is associated to a dedicated floating diffusion, while multiple of the first photodiodes 11, e.g. four adjacent ones in the corners of each pixel structure 1, share a common floating diffusion as illustrated, for instance.

Figure 6 shows a top view of a profile of an image sensor 40 comprising a 4x4 matrix of pixel structures 1 of Figure 1, wherein the profile is illustrated at a depth that is indicated by the dashed line B in Fig. 1. The surface at this depth is dominated by the depletion regions of the first photodiodes 11, wherein each of the pixel structures 1 of the image sensor comprises a 2x2 matrix of first photodiodes 11. In this embodiment, each pixel structure 1 comprises a color filter of one of the RGB colors such that a Quad Bayer pattern is realized.

Quad Bayer in this context means that all first photodiodes 11 of one pixel structure 1 are sensitive to the same visible wavelength range, e.g. one of blue, red and green, and a 2x2 matrix of these pixel structures 1 form a Bayer arrangement as illustrated. However, also alternative color filter arrangements, such as a single Bayer pattern, in which the 2x2 matrix of first photodiodes 11 of each pixel structure 1 comprises a color filter array in a Bayer pattern, are possible depending on the exact application and its requirements.

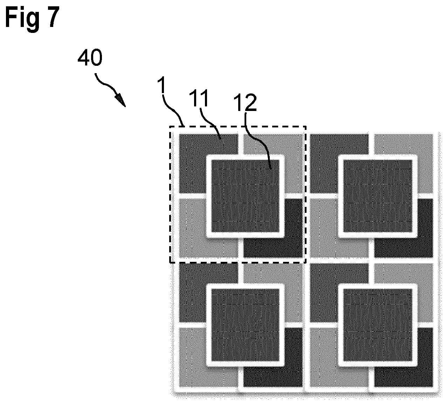

Figure 7 shows a top view of the image sensor 40 of Figs. 5 and 6, illustrating the 3D arrangement of a second photodiode 12 arranged in a centered manner above a matrix of first photodiodes 11. Therein, as illustrated in Figs. 1 to 4, the second photodiode 12 is arranged at a depth within the substrate body 10 (not shown in this Figure for illustration purposes) that corresponds to the mean absorption length of near-infrared, e.g. 850 nm and/or 940 nm, photons, while the first photodiodes 11 are arranged at a depth that corresponds to the mean absorption length of visible, i.e. 400-700 nm, photons.

The embodiments of the pixel structure 1 and the image sensor 40 shown in the figures represent exemplary embodiments, therefore they do not constitute a complete list of all embodiments according to the improved concept. Actual pixel structures and image sensor arrangements may vary from the embodiments shown in terms of additional components, shape and configuration, for instance. In particular, features shown in the various figures may be combined with each other and hence form additional embodiments according to the improved concept.

### Reference symbols

- 1: pixel structure
- 2: light entrance surface
- 3: surface
- 10: substrate body
- 11: first photodiode
- 12: second photodiode
- 13: implant isolation
- 14: isolation element
- 15: sense node
- 16: transfer gate
- 20: functional layer
- 30: readout component
- 40: image sensor
- d1: first depth
- d2: second depth

## Claims

1. A pixel structure (1), comprising
- a substrate body (10) having a light entrance surface (2);
- a plurality of first photodiodes (11) formed in the substrate body (10) at a first depth (d1) with respect to the light entrance surface (2); and
- a second photodiode (12) formed in the substrate body (10) at a second depth (d2) with respect to the light entrance surface (2); wherein
- the first depth (d1) corresponds to a photon absorption length in a material of the substrate body (10) at a first wavelength range; and
- the second depth (d2) corresponds to a photon absorption length in the material of the substrate body (10) at a second wavelength range that is different from the first wavelength range.

2. The pixel structure according to claim 1, wherein the pixel structure (1) is a backside illuminated pixel structure.

3. The pixel structure (1) according to claim 1 or 2, wherein the second photodiode (12) is formed at a surface of the substrate body (3) opposite the light entrance surface (2).

4. The pixel structure (1) according to one of claims 1 to 3, wherein the first wavelength range comprises at least a portion of the visible spectrum.

5. The pixel structure (1) according to one of claims 1 to 4, wherein the second wavelength range comprises at least a portion of the infrared spectrum, in particular the near-infrared spectrum comprising a wavelength of 850nm and/or 940 nm.

6. The pixel structure (1) according to one of claims 1 to 5, wherein the plurality of first photodiodes (11) comprise color filters and form an array of pixels, in particular a Bayer or Quad Bayer array.

7. The pixel structure (1) according to one of claims 1 to 6, wherein the plurality of first photodiodes (11) is arranged side-by-side and substantially gapless at the first depth (d1).

8. The pixel structure (1) according to one of claims 1 to 7, further comprising an implant isolation (13) formed at an intermediate depth in the substrate body that is arranged between the first depth (d1) and the second depth (d2).

9. The pixel structure (1) according to one of claims 1 to 8, further comprising isolation elements (14) of an opaque material with respect to the first wavelength range, wherein the isolation elements extend from the light entrance surface (2) at least to the first depth (d1).

10. The pixel structure (1) according to one of claims 1 to 9, further comprising a readout circuitry that is configured to detect photo-electrons generated by the plurality of first photodiodes (11) and the second photodiode (12).

11. The pixel structure (1) according to claim 10, wherein the readout circuitry is arranged at or on a surface (3) of the substrate body (10) opposite the light entrance surface.

12. The pixel structure (1) according to one of claims 1 to 11, further comprising
- a sense node (15) at a surface (3) of the substrate body (10) opposite the light entrance surface (2); and
- transfer gates (16) for transferring charges collected by the plurality of first photodiodes (11) and the second photodiode (12) to the sense node (15).

13. An image sensor comprising a plurality of pixel structures (1) according to one of claims 1 to 12, wherein the image sensor is configured to generate image signals at the first and the second wavelength ranges.

14. A method for manufacturing a pixel structure (1), the method comprising:
- providing a substrate body (10) having a light entrance surface (2);
- forming a plurality of first photodiodes (11) in the substrate body (10) at a first depth (d1) with respect to the light entrance surface (2); and
- forming a second photodiode (12) in the substrate body (10) at a second depth (d2) with respect to the light entrance surface (2); wherein
- the first depth (d1) corresponds to a photon absorption length in a material of the substrate body (10) at a first wavelength range; and
- the second depth (d2) corresponds to a photon absorption length in the material of the substrate body (10) at a second wavelength range that is different from the first wavelength range.
